(19) Europäisches Patentamt
European Patent Office
Office européen des brevets

(11) **EP 3 292 417 B1**

(12) **EUROPEAN PATENT SPECIFICATION**

(45) Date of publication and mention
of the grant of the patent:
**20.11.2019 Bulletin 2019/47**

(51) Int Cl.:
***G01R 19/165*** (2006.01)   ***G01R 21/133*** (2006.01)

(21) Application number: **16720448.6**

(22) Date of filing: **05.05.2016**

(86) International application number:
**PCT/EP2016/060135**

(87) International publication number:
**WO 2016/177857 (10.11.2016 Gazette 2016/45)**

(54) **ANALYSING A POWER CIRCUIT**

ANALYSE EINER LEISTUNGSSCHALTUNG

ANALYSE D'UN CIRCUIT DE PUISSANCE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **06.05.2015 GB 201507751
19.08.2015 RU 2015134753**

(43) Date of publication of application:
**14.03.2018 Bulletin 2018/11**

(73) Proprietor: **Torro Ventures Limited
London SW5 9AS (GB)**

(72) Inventors:
• **OGORODNOV, Sergey**
**London SW3 4DY (GB)**
• **BERARD, Philippe**
**Kenley**
**Surrey CR8 5EY (GB)**
• **Borini, Alberto**
**Fraz Roncocesi**
**42124 Reggio Emilia (IT)**

(74) Representative: **Ruuskanen, Juha-Pekka**
**Page White & Farrer**
**Bedford House**
**John Street**
**London WC1N 2BF (GB)**

(56) References cited:
WO-A1-2012/160062      WO-A1-2015/059272
WO-A2-2013/081719      US-A1- 2012 016 608

**Description**

FIELD OF THE INVENTION

This disclosure relates to power circuits, and more particularly to analysis of a power circuit and/or devices drawing current from a power circuit based on sampling of electric conditions in the power circuit. A method, apparatus and system for the analysis are also disclosed.

BACKGROUND

A power circuit is used e.g. in a building to provide power for electric devices connected thereto. A variety of devices can draw current from a power circuit. For example, electric appliances such as entertainment systems (e.g. TVs, audio systems, home cinemas etc.), computers, ovens, fridges, freezers, dishwashers, washing machines, dryers, irons and so forth domestic appliances, power tools, lighting appliances (e.g. fluorescent, halogen and LED lighting), inverters, saturated transformers, arc furnaces and so on can all be connected to a power circuit. Thus a power circuit can be loaded by a plurality of different electric appliances. This can make it difficult to assess how many devices and which particular devices are drawing current from the circuit. Also, the load on the circuit at a given point of time can be difficult to assess. Nevertheless, users might wish to have substantially real time information on power consumption and/or devices that are on and thus drawing current at a given moment. Further, information of a possible overloading situation might be desired. Overloading can lead to hazardous overheating and/or tripping of the circuit or a sub-circuit. Thus, it might be desirous to have a convenient system for control of power circuits and for informing users, e.g. homeowners or property managers, of the state and/or power consumption of a given power circuit. The system would desirably enable remote monitoring and/or control of the circuit and/or devices connected thereto.

The scenario has been complicated by rapid increase in the quantity and power rating of non-linear power electrical devices. Non-linear electric loads can introduce harmonics into an electric power system. Harmonic frequencies in the power grid can cause power quality problems. Power harmonics can cause voltage distortion which affects sensitive equipment. Also, nuisance tripping of circuit breakers may result. Besides that higher order harmonic currents may cause overheating problems in devices such as transformers and/or electrical wirings and connectors and other conductors, misfiring in variable speed drives, and torque pulsations in motors. Hence, power harmonics can become a power quality and even a safety problem. Thus, it would be advantageous to have an efficient and reliable way of analysing harmonics in a power circuit.

It is noted that the above discussed issues are not limited to any particular systems and power circuits but may occur in any power system where analysis and/or remote control of a power circuit and/or devices connected thereto might be desired.

The document WO 2012/160062 A1 discloses load monitoring of a system involving the detection of signal transitions associated with devices of the system.

Embodiments of the invention aim to address one or several of the above issues.

SUMMARY

In accordance with an aspect there is provided a method for monitoring a power circuit according to claim 7.

In accordance with another aspect a power circuit monitoring device according to claim 1 is provided.

Further details are defined in the dependent claims.

Certain more detailed aspects are evident from the detailed description.

SUMMARY OF DRAWINGS

Various exemplifying embodiments of the invention are illustrated by the attached drawings. In the Figures

Fig. 1 illustrates an example of a power circuit where the invention can be embodied;
Fig. 2 shows an example of a sensor device;
Fig. 3 shows examples of a breaker unit including a sensor device;
Figs. 4-11 relate to computations underlying signature vector determination;
Figs. 12 and 13 shows flowcharts according to certain examples, and
Fig. 14 shows data processing apparatus.

DETAILED DESCRIPTION

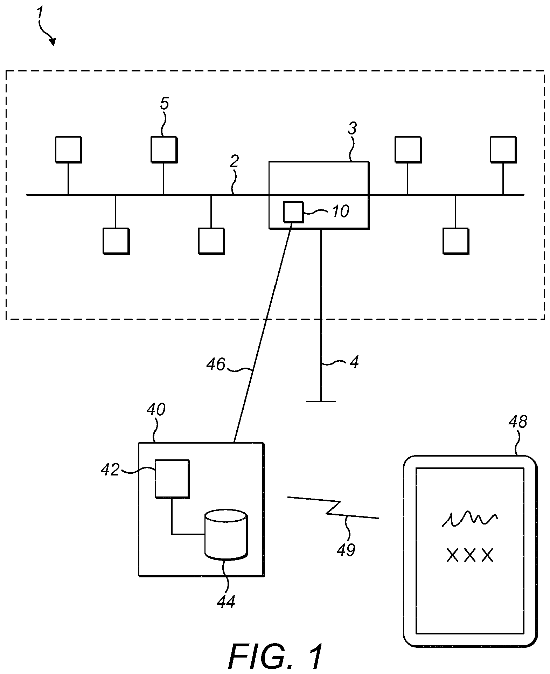

In the following the invention will be described with reference to a power circuit and a circuit breaker unit of the power circuit. Figure 1 shows an example of a power supply system 1 comprising a domestic power circuit 2 for supplying a plurality of different electrical appliances 5. The appliances can comprise various electric devices that can have ON and OFF states, such as ovens, hobs, radiators, water pumps, fridges, freezers, washing machines, TV's, radios and so forth domestic appliances, power tools, lighting appliances, inverters, saturated transformers, arc furnaces and so on. An appliance can also be seen as an aggregate of elementary appliances that can be ON or OFF. Devices 5 can draw current from the circuit 2 and can have different states.

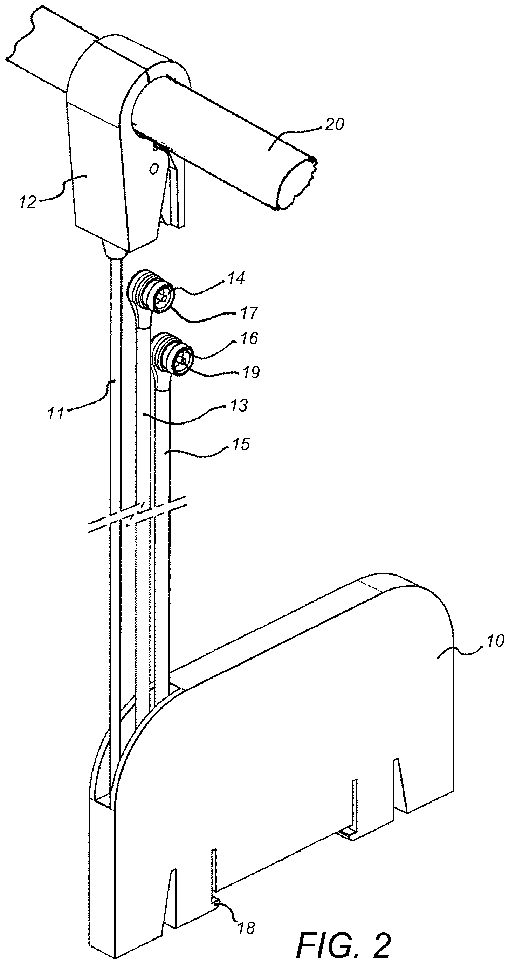

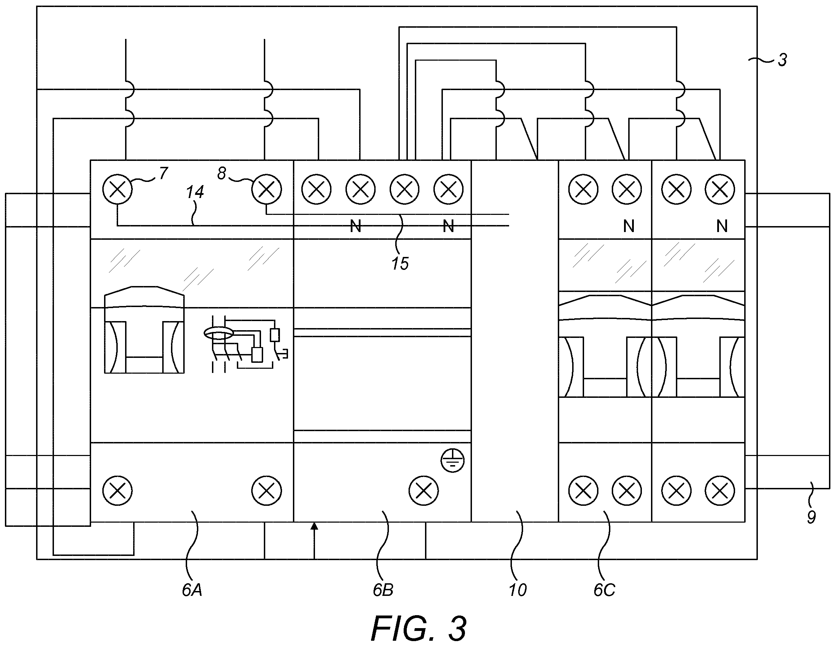

Figure 1 shows further a circuit breaker unit, or box, 3. A breaker box provides a power distribution unit (a panel) for an electricity supply system which divides an electrical power feed into subsidiary circuits, while providing a protective circuit breaker for each circuit in a common enclosure. Normally, a main switch and one or more residual-current devices (RCD) or residual current breakers with overcurrent protection (RCBO), are also incorporated. The breaker unit can be connected in the known manner e.g. to a national power grid 4. A breaker unit can comprise a plurality of breaker modules adapted for control of particular devices and parts of the power circuit 2. These modules are often referred to as circuit breakers, or simply as switches. An example of breaker modules 6 within a breaker unit 3 is shown in Figure 3. As will be explained in more detail with reference to Figures 2 and 3, a sensor device configured according to the principles of the invention can be provided in association with the breaker unit.

The sensor device can be provided with appropriate data processing and memory capabilities to perform analysis and other operations. Figure 2 shows an example of a sensor device 10 adapted for monitoring the power circuit of Figure 1. The sensor device encloses the required control electronics for analysis and control operations as described in more detail below. Further, the sensor device can comprise communications interface, for example for wireless or fixed line communications.

The sensor device 10 can be installed inside the breaker box unit 3. Figure 2 shows a particular design that can be installed without use of any tools, or possibly with basic tools such as tools, keys and/or codes needed to open a front panel of a breaker box. Attachment to the components of the breaker box can be arranged by suitable clips, hooks or the like. The Figure 2 device is arranged to have hooks 18 that engage with a fixing rail of a breaker box. The installation of the device does not require wire disconnection either. Thus an easy, fast and fool-proof installation of the sensor device can be provided.

The breaker box can be of standard structure. For example, a standardised breaker box design is used across Europe, the design allowing breaker modules to be fixed by a DIN rail (DIN is a German standard by the Deutsches Institut für Normung). Use of fittings that engage with the DIN rail allows use of a standard device in various applications that is easy to assemble. Such device also has the appearance of an "original" rather than "aftermarket" installation.

An example of DIN circuit breaker unit is shown in Figure 3. The unit 3 comprises different types of breaker modules 6A, 6B and 6C, each module being compliant with the DIN standard. The main breaker 6A is typically at two or four DIN modules wide. The breaker module or switch can integrate a security circuit breaker.

The sensor device of Figure 2 is installed preferably as close as possible to the main breaker 6A. According to a possibility the sensor device 10 is placed adjacent the main breaker module 6A. The width of the sensor device can be e.g. that of two DIN modules, or 35.6 mm. The depth of the device can be, according to DIN standard, e.g. 44 mm. The sensor device and its wirings is preferably designed so that no part thereof exceeds the clearance between the breaker and the rear of the front panel of breaker box.

The sensor device 10 can be connected to the circuitry by two contacts 14 and 16. The connection can be provided via appropriate location at or near to the main breaker 6A. A toroid 12 for engagement around the phase wire 20 of the circuitry is also provided. Contacts 14 and 16 are used to measure the voltage and harvest the energy to operate the electronics of the device. The toroid 12 is for measuring the current drained by the devices connected to the circuit.

The device can comprise two specifically designed probes 14 and 16 that are arranged to be connected to the "wrong ends" of front screws 7, 8 of a standard breaker module. The pitch of the front screws is defined by the DIN standard, and can be 17.7 mm or a multiple thereof. Because of the possibility of the screw holes having varying pitch, as shown by Figure 3, the probes can be provided at the loose ends of wires 13 and 15, rather than in a fixed assembly, thus providing flexibility in mounting to different pitches.

The connectors can be configured to be fastened to an external part of a contact element of a breaker module, such as the screw end of other visible fixing element, through an opening in the breaker module. The probes 14 and 16 can comprise magnetic connectors that can be simply pushed into appropriate openings such as front or side end screw holes for neutral and phase wiring. Because of the magnets 17 the probes 14 and 16 self-attach to the screw heads and thus ensure contact between the contactors 19 and the wire fixing screw ends at the breaker module. Thus no tools are needed for wiring the device into the breaker unit. Other ways to attach the contactors of the probes to the screw ends are also possible.

The clearance between the front of the breakers modules and the rear of breaker box panel is typically small, even as little as about 5 mm. The contacts are preferably made small enough to enable closing the cover of the breaker box. Thus it is considered advantageous to connect the sensor device to the wirings of the power circuitry by three co-moulded thin cables. The cables can be ultra-flexible with silicon insulating jacket, for example like the ones used in testers and scopes probes. This kind of cables allow for a higher insulation voltage and the possibility to be bended on very short radius without damage. A fuse can be provided at the power cable, and not inside the sensor cover. This enable inspection and change thereof without disconnection and removal of the sensor device from the breaker box.

The cabling 11 to sense current can have the colour of phase wiring. The two cables 13 and 15 to measure the voltage and harvest the power can have the colours of phase and neutral. The colouring of the wiring may change on country basis.

The electronics for sensing and analysis operations can be provided in a plastic enclosure, for example ABS or Polycarbonate. To fix the device to the DIN rail, sliding plastic hooks 18 (with spring pre-charge) can be used. Other solutions like "snap-in" rubber parts can also be used to simplify the mechanical design.

The assembly of the monitoring device can thus comprise inserting the monitoring device in a slot that is intended for a breaker unit and attaching the monitoring by the clips to the railing of the breaker unit.

Returning to Figure 1, the monitoring and control system can further comprise a central data processing unit 40. The unit can comprise a central database 44 and appropriate data processor capability to process information from a plurality of local power systems such as system 1. The local sensor device 10 is connected via an appropriate communications link 46 with the central unit 40. At least a parts of the data communications may occur via a wireless link. For example, the local device 10 can have its own IP address and communicate via a wireless local area network (WLAN) or via a cellular system. Processing and storage of information by the sensor device 10 and related to the power circuit system 1 can be distributed between devices 10 and 40.

Figure 1 shows further a user terminal 48. The user terminal can comprise e.g. a smartphone, tablet, laptop or a desktop computer. Preferably the user terminal is a mobile device that communicates with the data processing unit 40 via wireless link 49. A user, for example the householder or a property manager can be displayed information on the power circuit and/or devices connected thereto derived based on information measured by device 10. The user terminal can also be used to input control instruction regarding the power system 1 and/or devices 5 connected thereto. In accordance with a possibility the user of the terminal downloads an appropriate client application enabling the display and control operations.

As mentioned, the power circuit 1 can be loaded by a plurality of different electrical appliances 5. In a normal alternating current power system, the current varies sinusoidally at a specific frequency, usually 50 or 60 hertz. When a linear electrical load is connected to the system, it draws a sinusoidal current at the same frequency as the voltage (though usually not in phase with the voltage). However, an increased quantity and power rating of highly non-linear power electrical devices is being used. Such non-linear loads cause current harmonics. When a non-linear load, such as a rectifier, is connected to the system, it draws a current that is not necessarily sinusoidal. The current waveform can become quite complex, depending on the type of load and its interaction with other components of the system. Regardless of how complex the current waveform becomes, as described through Fourier series analysis, it is possible to decompose it into a series of simple sinusoids, which start at the power system fundamental frequency and occur at integer multiples of the fundamental frequency.

Power harmonics can cause voltage distortion which affects sensitive equipment. It can also cause nuisance tripping of circuit breakers. Besides that higher order harmonic currents may cause overheating problems in devices such as transformers and/or electrical wirings and connectors. Hence, power harmonics can become a power quality and even a safety problem.

On the other hand, analysis of power harmonics can be usefully utilised to identify appliances that are being used and e.g. control possible overloading situations. Power harmonics analysis refers to a study of waveform distortion resulting from non-linearity of electrical loads on a power circuit. Power harmonics analysis can be performed in time domain or frequency domain. The frequency information can be obtained through techniques such as Fourier Transform (FFT) of the original time domain signal. The two domains offer two different perspectives of a waveform and can both be used for analysis of power harmonics.

In accordance with an example a sensor device connected to a power circuit samples and calculates FFT's of the first nine current harmonics providing information on amplitudes and phases. The harmonics can be averaged over a sampling window. The size of this sampling window can be, for example, fifteen seconds. The resulting harmonics vector can then be used in determining a signature vector, taking also some further information into account, for a given device, or a group a devices.

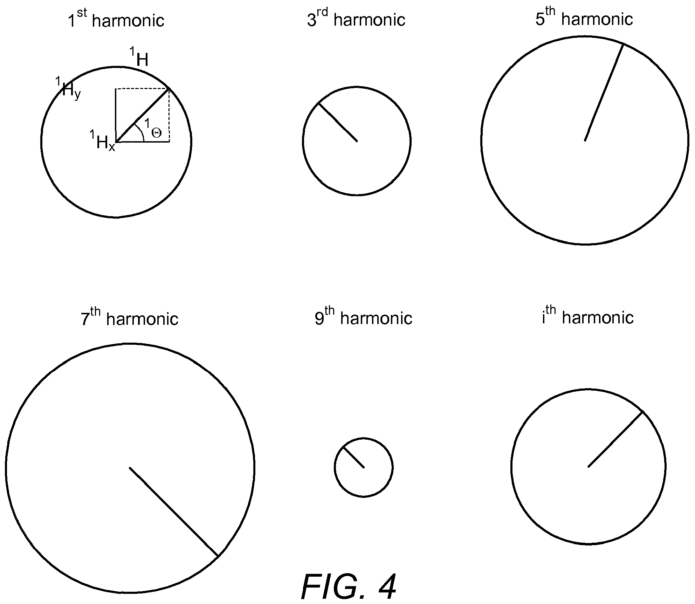

The following presents in more detail certain principles of possible harmonics analysis to determine a signature vector for at least one device with reference to Figures 4 to 10 and tables 1 to 5.

Figure 4 illustrates an example of odd harmonics. The definitions for these are presented in table 1 below:

Table 1

| | Definition | Description |
|---|---|---|
| $^1H$ | $= (^1H_x, ^1H_y)$ | $^1H$ is the 2D representation of the 1st harmonic vector, $^1H_x$ is the x-axis coordinate of $^1H$ and $^1H_y$ is the y-axis coordinate of $^1H$. |
| $^1\Theta)$ | $= <^1H$ | $^1\Theta$ is the angle formed by $^1H$ and the horizontal. |
| $(^{2i+1}H, ^{2i+1}\Theta)$ | $= (^{2i+1}H_x, ^{2i+1}H_y, <^{2i+1}H)$ For i = 0, .., 4 | Generally for any odd harmonic among 1st, 3rd, 5th, 7th and 9th harmonics, this is the $i^{th}$ vector related to the $i^{th}$ harmonic. |
| $^{2i+1}H(T)$ $^{2i+1}\Theta$ (T) | $= (^{2i+1}H_x(T), ^{2i+1}H_y(T))$ $= <^{2i+1}H(T)$ Where T is the time of a sample by the sensor and T+1 is the next sample after time T. | These represent the $i^{th}$ vector related to the $i^{th}$ harmonic sampled at T time. |
| H(T) $\Theta$(T) | $= (^{2i+1}H_x(T), ^{2i+1}H_y,(T) <^{2i+1}H(T))$ For i = 0, .., 4 | H(T), $\Theta$(T) represents the entire reading vector for the 5 odd harmonics. |

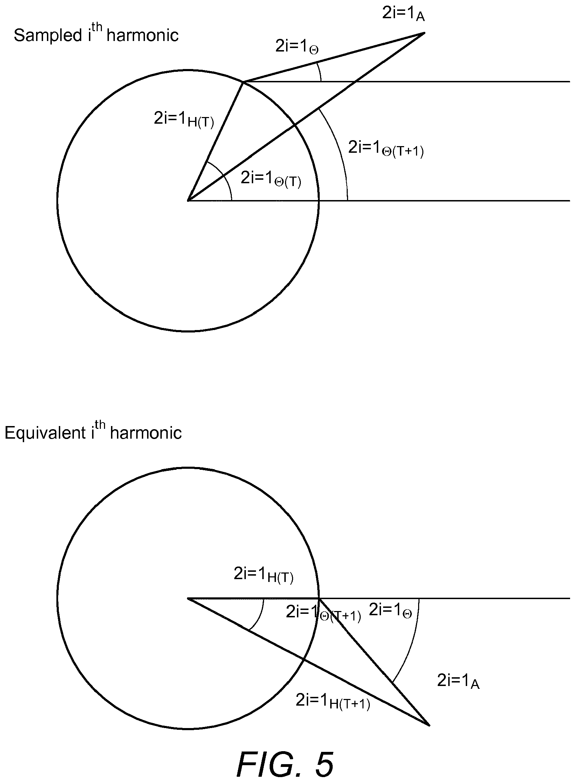

Figure 5 shows the effect of an added appliance on $i^{th}$ harmonic. The details of these are given by table 2 below:

Table 2

| | Definition | Description |
|---|---|---|
| $^{2i+1}H(T)$ $^{2i+1}\Theta$(T) $^{2i+1}H$ (T+1) | Vector sample at T | A is an appliance added after the last sample at time T. |
| $^{2i+1}\Theta(T+1)$ | Vector sample at T+1 | The sensor sends a new sample at T+1 time following the addition of an appliance. |
| $(^{2i+1}A, ^{2i+1}\Theta)$ | $=(^{2i+1}A_x, ^{2i+1}A_y, <^{2i+1}H)$ For i = 0, .., 4 | A is an appliance that is added after the last sample at time T. |
| **Equivalent $i^{th}$ harmonic** | After rotation by $^{2i+1}\Theta$ (T) | Sample at T time will be shifted by an angle of $^{2i+1}\Theta(T)$. An assumption is to set $^{2i+1}\Theta(T) = 0$ as it bears no consequence on the calculation of $(^{2i+1}A, ^{2i+1}\Theta)$. Assuming $^{2i+1}\Theta(T) = 0$ is equivalent to: • $^{2i+1}H_x(T)= \underline{^{2i+1}H(T)}$ • $^{2i+1}H_y(T)=0$ Where $\underline{X}$ is the vector length of X |
| $^{2i+1}A$ | Law of Cosines | $^{2i+1}A = [\underline{^{2i+1}H(T+1)}^2 + \underline{^{2i+1}H(T)}^2 - 2.Cos(^{2i+1}\Theta(T+1)). \underline{^{2i+1}H(T+1)}^2 . \underline{^{2i+1}H(T)}]^{1/2}$ |
| $^{2i+1}\Theta$ | Law of Sines | $Sin(^{2i+1}\Theta) = Sin(^{2i+1}\Theta(T+1)) . \underline{^{2i+1}H(T+1)} /^{2i+1}A$  $^{2i+1}\Theta = ArcSin [Sin(^{2i+1}\Theta(T+1)) . \underline{^{2i+1}H(T+1)} /\underline{^{2i+1}A}]$ |

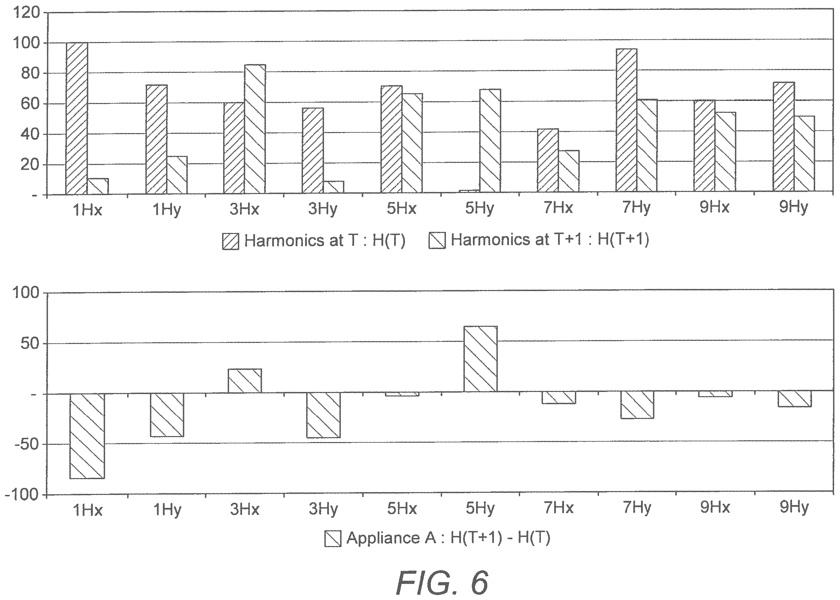

The chart of Figure 6 illustrates a chart of harmonics vector analysis between T and T+1 samples. The details of this analysis are given in table 3 below:

Table 3

| | Definition | Description |
|---|---|---|
| $^{2i+1}H_x(T)$ | $= \underline{^{2i+1}H(T)} . Cos (^{2i+1}\Theta(T))$ | For any sample $^{2i+1}H_x(T)$ is calculated by projection of the vector $^{2i+1}H(T)$ on the x-axis using the angle $^{2i+1}\Theta(T)$ for the projection. |

(continued)

| | Definition | Description |
|---|---|---|
| $^{2i+1}H_y(T)$ | $= \dfrac{^{2i+1}H(T)}{} \quad . \quad \text{Sin}$ $(^{2i+1}\Theta(T))$ | For any sample $^{2i+1}H_y(T)$ is calculated by projection of the vector $^{2i+1}H_xT$) on the y-axis using the angle $^{2i+1}\Theta(T)$ for the projection. |
| **A Vector** | $= H(T+1) - H(T)$ | A vector is calculated by difference of the odd harmonics for real and imaginary coordinates. |

An assumption in the calculation of the appliance vector can be made that only one appliance is switched on or off between T and T+1 harmonic samples.

If more than one appliance is switched on or off during the sample period of fifteen seconds, a compound appliance signature is generated in the database. This signature vector may remain orphan i.e. never or very rarely matched with any other calculated appliance vector unless the two appliances are always switched on together. However, this may occur with certain devices operating in groups, and therefore a system administrator may wish to retain also these vectors.

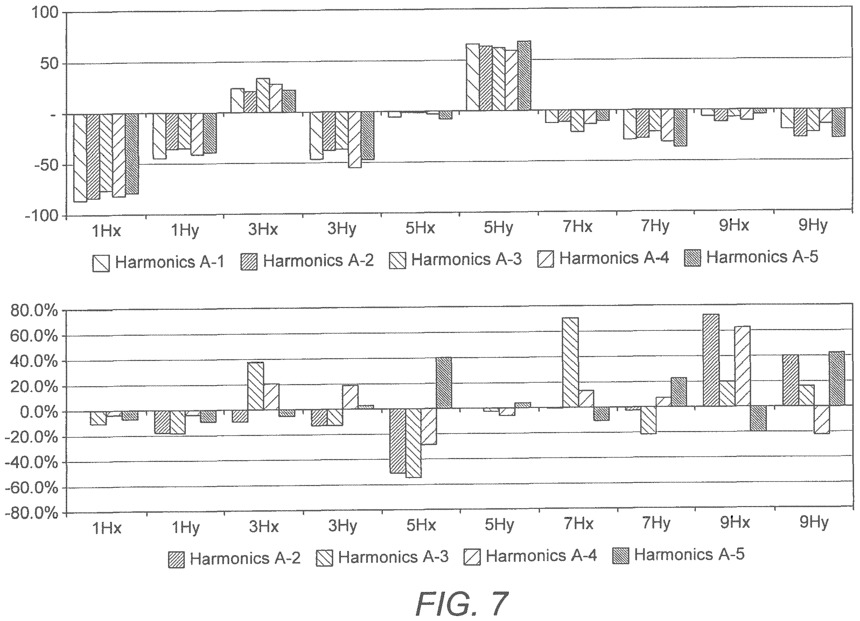

Figure 7 shows fluctuations of harmonics and normalisation thereof. Details of this are given below in table 4. These can be computed based on

$$\varepsilon(_RA, A^n) = ||corr(_RA, A^n)| - 1|$$

where $\varepsilon (_RA, A^n)$ is the deviation from 1 of the correlation between the vectors $_RA$ and $A^n$ or the deviation.

Fluctuations occur when harmonics vector for an appliance is calculated based on difference of the harmonics sampled at T and T+1. Error function $\varepsilon(_RA, A^n)$ can be used to calculate the difference for each component of the vector between the harmonics vector of $_RA$ (the reference) and $A^n$ (the vector calculated).

The objective is to calibrate $\varepsilon(_RA, A^n)$ in terms of precision to be able to match calculated appliance vectors $A^n$ with appliance vector reference $A^0$ stored in a database of appliance vectors. Because $\varepsilon(_RA, A^n)$ is the error function between $_RA$ and $A^n$ the matching algorithm shall look at minimizing the value of the error function which gives the closest match for $A^n$.

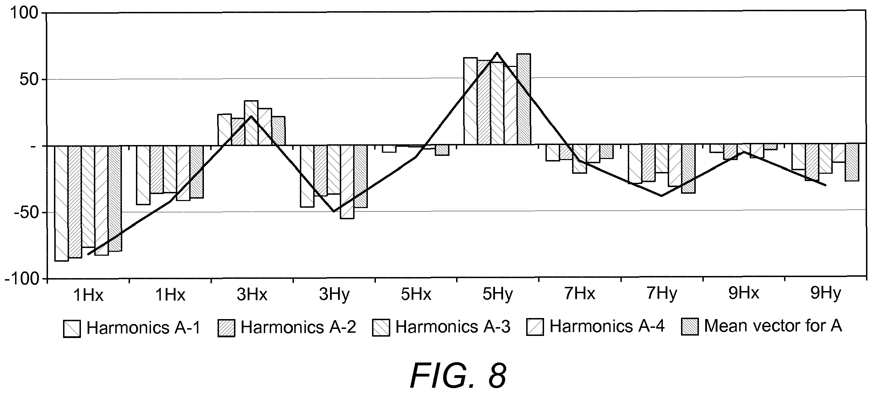

Mean calculation for appliance harmonic vector is illustrated by Figure 8. This can be written as

$$_RA(n) = \text{Mean}(A^1, .. A^n)$$

where
$A^1, .. A^n$ are matched signatures.

A (n) is the mobile average since the first entry in the database $_RA$ (1).

$$_RA(n+1) = [n . {}_RA(n) + A] / (n + 1)$$

The first time an appliance is discovered on the electrical power circuit, an entry is created in a signature database $_RA$ (1). The value stored in the database used as the reference $A^0$ for the appliance harmonics is averaged to reflect the change of electrical conditions.

When an appliance signature is matched with $_RA(n)$ stored in the database, the value stored in the database can be altered and replaced by the new mean $_RA$ (n+1). Over the time the mean converges towards the true appliance signature.

In order for the algorithm to calculate the mean, the database can store the number of matching occurrences, n, as well as the mean value $_RA(n)$.

In addition to the relative steady signals of the harmonics sampling window, analysis of transients is also provided. Transients in general refer to short duration signals on the power circuit. Transients usually occur during sudden transition of states of electrical devices (ON/OFF) whereas steady state signals are constant or cyclical signals that are repeated with time when the electrical devices have settled down to a stable state of operation. Due to their short duration, transients can be difficult to analyse compared to steady state signals. Transients typically require continuous monitoring and recording of the signal at high sampling rate. Techniques such as edge detection can be employed to initiate the capturing of the transient waveforms. On the other hand, steady state signals are obtained only when the waveform has stabilized and thus require lower resolution.

In accordance with the herein described principles both transients and steady state signals are utilised to provide information for the analysis of power harmonics.

The sensor can be adapted to sample the transient following a change in consumed power over a transient sampling window that is shorter than the harmonic sampling window. For example, the transient sampling window can be about 250 ms. The transient window can be divided in ten values corresponding to the peaks of the transient current of the fundamental phase 50/60 Hz.

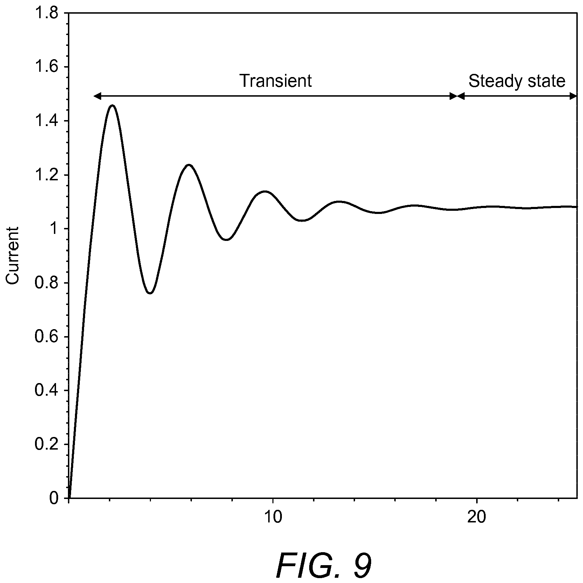

Figure 9 illustrates graphically the transient and steady states. Information on the transient state curve can be sampled and stored in the database. Details for the determinations are shown in table 4 below.

Table 4

| | Definition | Description |
|---|---|---|
| $^i$Tr | = $i^{th}$ current transient For i = 1 to 10 | $^i$Tr is the current value during sampled during the $i^{thi}$ interval of 25ms |
| Tr | = ($^1$Tr, $^2$Tr, ..., $^{10}$Tr) | The first 10 values of the current sampled every 25ms together make up for the 250ms window of transient state vector noted Tr. |
| Min(Tr) | =Min ($^i$Tr) For i = 1, .., 10 | Min (Tr) is the minimum value of the transient current states during the 250 ms of sampling. |
| Max(Tr) | =Max ($^i$Tr) For i = 1, .., 10 | Max (Tr) is the maximum value of the transient current states during the 250 ms of sampling. |
| <u>Tr</u> | =Max(Tr)-Min(Tr) | <u>Tr</u> is the amplitude of the transient for the first 250 ms. |

Characteristics of a transient signal depend heavily on the instantaneous state of the electrical system when it occurs. Therefore, the amplitude of the transient waveform may differ significantly for each measurement instance. Accurate modeling is complicated and can require all possible states to be taken into consideration.

In this example $^{10}$T is assumed to be the point where the current of the fundamental has reached its steady level. Therefore $^{10}$T can be used as the steady state entry.

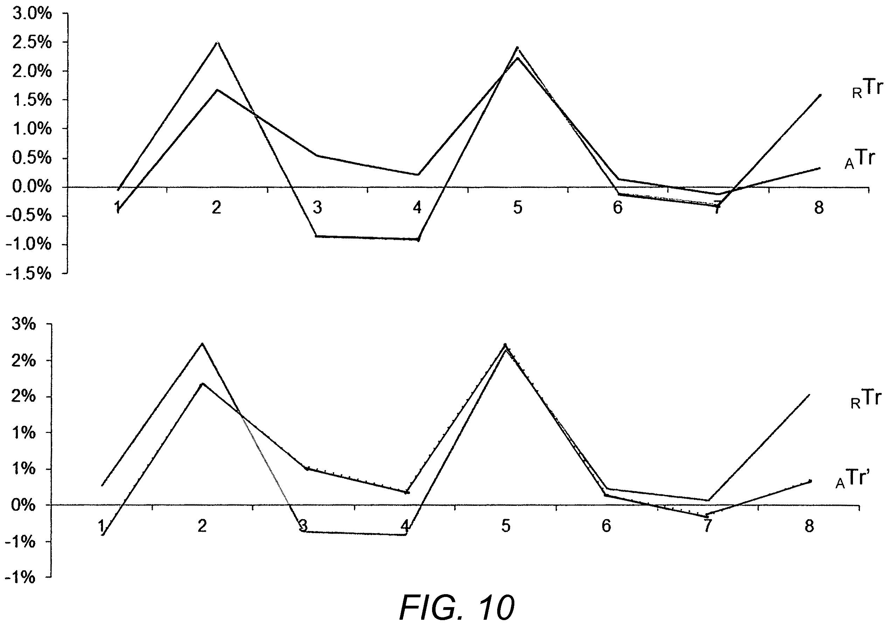

Figure 10 illustrates normalisation of a transient state. More particularly, the upper graph shows the normalised value of transient relative to the $^{10}$Tr transient and the lower graph shows a curve for a trended transient state. Table 5 below shows the details of the computations.

Table 5

| | Definition | Description |
|---|---|---|
| $^i$Tr | $^i$Tr' = ($^i$Tr - $^{10}$Tr) /$^{10}$Tr | $^i$Tr' is the normalised value of the $i^{th}$ transient relative to $^{10}$Tr, the last transient of the sampling window (250 ms) <br> $^i$Tr' measures the deviation of the $i^{th}$ transient with the steady state value. |
| ($_A$Tr', $_R$Tr) | $^i_A$Tr' = [$^i_A$Tr' - Min($_A$Tr)] '. $_A$<u>Tr</u>/ <u>Tr</u> +Min($_R$Tr) | The shape of the curves between the appliance A and the reference R are trended to be more accurately compared and matched. |
| <u>ε/$_R$Tr,$_R$Tr)</u> | = ‖Corr($_A$Tr,$_R$Tr|-1| | $ε(_R$Tr,$_R$Tr)$^2$ is the deviation from 1 of the correlation between <u>the vectors</u> $_R$Tr and $_A$Tr or the deviation. |

Below vector Tr' is noted Tr after normalisation and trending reshaping. Only nine vectors of transient states are considered equivalent to ($^1$Tr', ..., $^9$Tr').

The transient vector Tr can be used together in conjunction with the harmonic vector for the signature calculation.

In reality there are two different transients, one relating to a switch-on event and another transient following a switch-off event. Conversely to the harmonics that are absolutely symmetric for switch-on and switch-off, transients are different due to the nature of the electrical event occurring on the circuits.

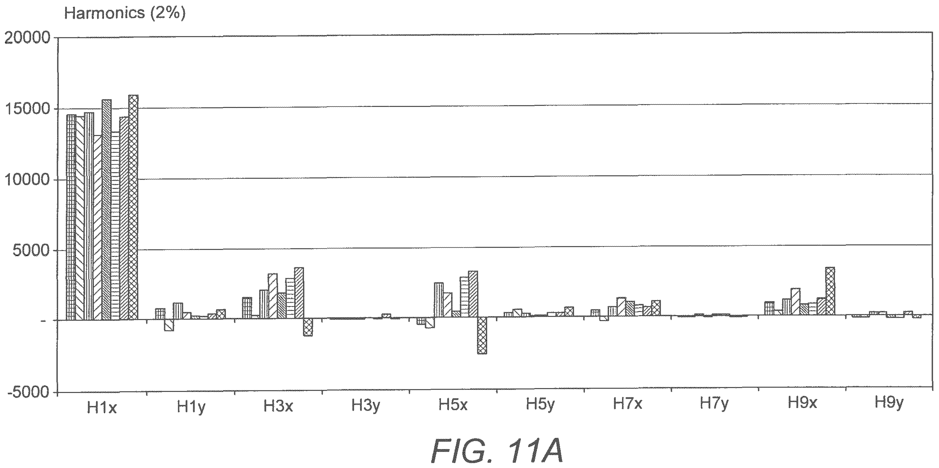

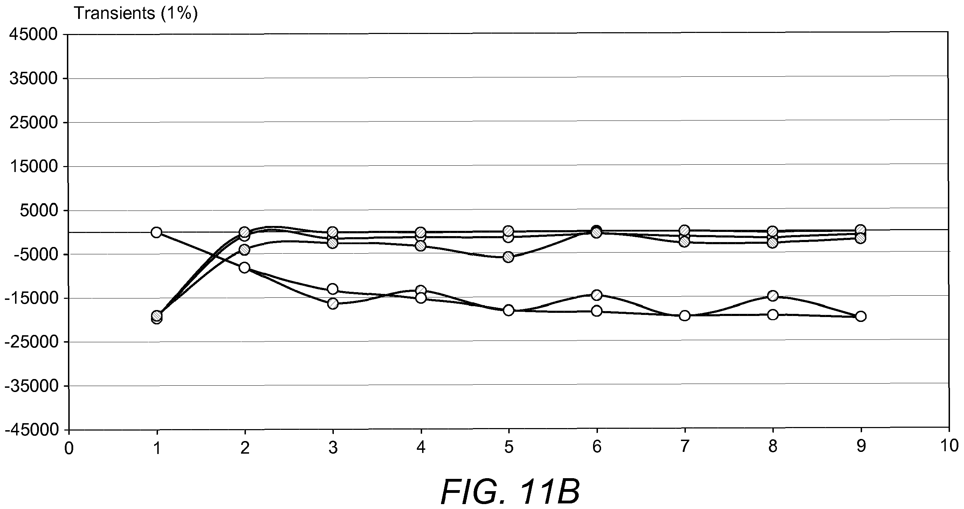

Figures 11A and B illustrate calculation of harmonics and transients for eight appliances. To discover signatures of appliances data points (1000 test data points in this example) are correlated in groups and then the mean for each harmonic and transient is extracted. As can be seen from Figure 11B, the transients form two distinct groups. In one of the groups appliances have been switched off and thus the transient goes down to zero quickly. In the other the appliances have been switched on and thus longer lasting disturbance is caused.

Because the transient can be related to SWITCH-ON or SWITCH-OFF events when an appliance is switched on or off, the algorithm only needs to capture the correct transient. For instance when a SWITCH-ON transient for an appliance A is matched with a reference R in the database the transient vector $_R$Tr is recalculated as follows:

$$_R\text{Tr}(\text{ON}, n+1) = [\, n \cdot {}_R\text{Tr}(\text{ON}, n) + {}_A\text{Tr}\,] / (n + 1)$$

where $_R$Tr(ON, n) is the transient reference stored in the database and calculated as the mean of the n matching values.

On a SWITCH-OFF event the algorithm works exactly the same way using the SWITCH-OFF transient instead.

A signature vector can now be calculated as follows.

Definition of the harmonic vector of an appliance A can be gives as

$$_A\text{H} = (\ {}_A^{1}\text{H}_x,\ {}_A^{1}\text{H}_y,\ {}_A^{3}\text{H}_x,\ {}_A^{3}\text{H}_y,\ {}_A^{5}\text{H}_x,\ {}_A^{5}\text{H}_y,\ {}_A^{7}\text{H}_x,\ {}_A^{7}\text{H}_y,\ {}_A^{9}\text{H}_x,\ {}_A^{9}\text{H}_y\ )$$

Definition of the transient vector of an appliance A can be given as

$$_A\text{Tr}(\text{ON}) = (\ {}_A^{1}\text{Tr}',\ {}_A^{2}\text{Tr}',\ {}_A^{3}\text{Tr}',\ {}_A^{4}\text{Tr}',\ {}_A^{5}\text{Tr}',\ {}_A^{6}\text{Tr}',\ {}_A^{7}\text{Tr}',\ {}_A^{8}\text{Tr}',\ {}_A^{9}\text{Tr}'\ )\ (\text{ON})$$

And

$$_A\text{Tr}(\text{OFF}) = (\ {}_A^{1}\text{Tr}',\ {}_A^{2}\text{Tr}',\ {}_A^{3}\text{Tr}',\ {}_A^{4}\text{Tr}',\ {}_A^{5}\text{Tr}',\ {}_A^{6}\text{Tr}',\ {}_A^{7}\text{Tr}',\ {}_A^{8}\text{Tr}',\ {}_A^{9}\text{Tr}'\ )\ (\text{OFF})$$

Definition of the signature vector of an appliance A can be computed based on these two as:

$$_A\text{S} = (\ {}_A\text{H},\ {}_A\text{Tr}(\text{ON}),\ {}_A\text{Tr}(\text{OFF})).$$

$_A$S is a twenty eight coordinates vector, and provides the signature vector of an appliance is made up of its harmonic vector and transient vector.

Error function can be applied in determining whether a signature vector is found:

$$\varepsilon(A,\ R)\ =\ [\text{Weight}(H)\ \times\ \varepsilon(_A\text{H},\ {}_R\text{H})\ +\ \text{Weight}(Tr)\ \times\ \varepsilon(_A\text{Tr}(\text{ON/OFF}),\ {}_R\text{Tr}(\text{ON/OFF})]$$

where appliance A is disaggregated when $\varepsilon(A, R)$ is minimum and

$$\text{Weight}(H) + \text{Weight}(Tr) = 1$$

The algorithm is using a machine learning approach to adjust Weight(H) and Weight(Tr) for each installation. Following an initial period equivalent to a few thousands samples, three to five days on average, the algorithm will look at what are the best values of the weight that increase accuracy, measured on variance between the sampled values for a given signature, and the disaggregation coverage. The disaggregation is the share of samples that have successfully been matched with the discovered signatures.

Parameter for signature reference, $_R$S, for a disaggregated appliance that has been matched with a n occurrences is given by

$$_R\text{S} = (\ {}_A\text{H},\ n\text{H},\ {}_A\text{Tr}(\text{ON}),\ n\text{Tr}(\text{ON}),\ {}_A\text{Tr}(\text{OFF}),\ n\text{Tr}(\text{OFF}),)$$

By this the value stored as the signature reference in the database can be averaged over matching occurrences. By averaging the signature the algorithm allows the electrical circuits to change over time and the general behavior of an appliance to also slightly change reflecting the electrical modifications of the appliance.

During system initiation phase, data is collected at test data points. The system is run for an initial period in order to collect sufficient data and the data collected is then analyzed. The results can be e.g. hundreds seemingly different signatures which may or may not be for a single device. The algorithm described above can be used for the first time to extract from the hundreds of data samples the signatures that initially populate the database. A benefit of initiating the system based on hundreds of data samples instead of logging the signatures based on the first electricity event is that the mean values of the harmonics and transients used as the signature basis are based on tens of occurrences instead of being based on just one or the first occurrence, and are thus more accurate.

An unsupervised machine learning mechanism can be used by the control system. A machine learning mechanism, or engine, can be provided to assist in the speed and/or completeness of built-in of records of individual appliances in the control system. Initially the control system can collect a large number, e.g. tens of thousands of readings, or samples, from mains circuits and store these reading records in a database as detailed above. The records stored can include the harmonics, the transient states, the true and reactive powers as well as a Boolean that indicates whether the record is a switch on or a switch off.

A three stage process may be provided so that steps there are steps for clustering of measurements samples, training of a machine learning engine and classification of subsequent samples using the trained machine learning engine.

The initial readings can be initially processed and then clustered using an appropriate nearest neighbouring algorithm. The algorithm can be adapted to avoid too large spread in the neighbouring strings and to detect unusual gap patterns to break the strings into smaller clusters. The following processing step can involve a deep learning mechanism using a support vector machine (SVM). Clusters found during the initial step are fed into the SVM learning module that outputs a multi-class SVM matrix. The samples can generally be of non-linear and non-Gaussian nature. The SVM module can rely on a specific kernel method using a 5$^{th}$ degree polynomial function and a combination of Euclidian distances and correlation.

In the last processing step, the SVM Matrix can then be used to automatically classify any new reading coming from the sensor.

The reading can be applied to the SVM Matrix and the most likely match suggested by the artificial intelligence engine. At this stage the results from three methods, namely Machine Learning classifier, basic active power comparison and Euclidian distance algorithm can be compared for matching, and the most likely signature can be elected by the control system based on the comparison. According to a possibility the comparison is arranged such that when at least two methods out of the three indicate the same outcome the algorithm selects the signature matched by these two methods.

Samples may be provided e.g. every time there is a detected ON or OFF event. The Machine Learning process can be highly iterative and arranged such that every learning cycle adds additional information to the clusters, thereby refining the knowledge of each signature. An initial signature that may have looked like a hyper sphere due to the nature of the clustering will over the time of the successive learning cycles re-shape to look like a rugby ball, or may take the shape of some even more unexpected evolutions.

The iterative nature of the unsupervised machine learning engine can also be arranged to allow the system to promote new signatures as well as demote obsolete signatures. For example, this can be useful in a household where appliances can be replaced over time.

Also, each iteration refines the definition of a signature. This allows tracking of changing operation patterns of critical appliances. For example, phase shift between voltage and current can provide industrial users such as a manufacturer or a process industry facility with valuables insight with regards to how behaviour of a specific machine or device, e.g. a pump is changing, e.g. degrading. This can be determined to mean that the observed apparatus is losing its efficiency, and needs attention.

A generic database of signatures can be build. The database can be shared by a plurality, or even all users. Over time, and when the signatures are tagged e.g. like 'Dishwasher' or 'Washing Machine', whenever a reading is close enough to an existing generic signature is detected, the user can be offered the opportunity to rely on the signature database to tag their own signatures.

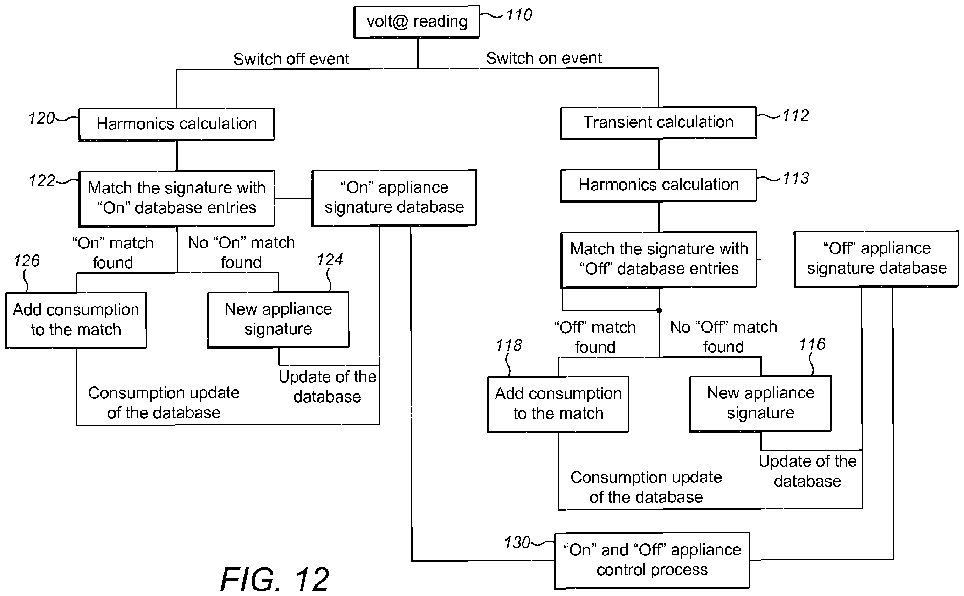

Figure 12 shows a flowchart for an algorithm following detection of a change in a state of a device connected to a power circuit. A sensor device gives a reading at 110 and based thereon either a switch-on or a switch-off event can be detected. This can be determined based on the consumed power going up (switch-on) or down (switch off) sampled at the end of the transient period.

When the sensor detects a switch-on event, the switch-on event branch is followed. The sensor reading is compared to the previous reading to calculate a signature vector for the device. As explained above, the signature vector can be computed as a compound of transient and harmonics computed at 112 and 113. The signature vector can then be matched at 114 to entries at a database.

At this stage the signature vector can be mapped only with a list of appliances that are known and marked to be in "Off" state in the database of appliances. There is no need to map the signature to the "on" entries since the device has been determined as being one that has just been switched on and thus could not have been on previously. Thus the device is necessarily still marked "off" in the database at this stage, as the update follows the mapping stage.

If the signature matches an appliance in the database with the switched Off state, it's state is changed to "On" in the database of appliances.

If the Signature cannot be matched with the list of "Off" appliances, a new signature entry can be created at 116 for the device in the database and added at 117 to the database. At this stage the newly added device can be associated with status "On".

Similar logic can be applied to operation in response to a switch-off event. In the switch-off event tree branch no transient is needed as a part of the signature and only harmonics are computed at 120 and used to match at 122 with the "On" state entries at the appliance database. This is because the appliance can be assumed to be in a steady state.

If the signature does not map to any entry in the on database, then a new appliance signature entry can be added to the database. Thus a new appliance signature is created at 124 and the database is updated accordingly.

When an appliance is switched between ON and OFF states the sensor device can send a message to the central unit providing a mediation platform. A message can inform the central unit that a new appliance has been identified and a new data record has to be added. Thus the system is self-learning any new device added to the power circuit. If a match has been found the message can notify that appliance has been matched by the sensor with its local database and the sensor sends an updated data record to replace the existing appliance data record.

Undefined situations may occur. A process of control of "On" and "Off" appliance database that removes the anomalies such as an appliance that remains "On" or a Switch-On event showing the same appliance is already stored at "On" state is provided at 130. In a double ON or double OFF event for the same appliance, it can be assumed that the appliance has been switched ON and OFF or OFF and ON within the same sampling window. Effectively, the appliance will remain respectively ON and if it was already ON and OFF if it was OFF.

Once the device and its state is identified it is possible to compute power consumption at 118 and 126. The power consumption values can be added to the record of the matching device in each branch after the device has been identified. Power consumption information can be delivered in substantially real-time to relevant user terminals and/or stored for later use.

The mapping can be done locally at the sensor device or centrally. In the first mentioned option the signatures are stored locally at device 10. In the latter the signatures are stored at the central unit. Data communicated between the local unit and the central units will then depend on the arrangement.

When the sensor is switched on or otherwise booted a request can be sent by the sensor to the appliance database in order to receive a copy of the current appliance data records. The sensor rebuilds the tree of appliances as stored in the database.

The system is used to monitor for power consumption. This can be provided by determining all devices that are ON and their consumed power. The computations can be provided locally or centrally. A user of the user terminal 48 of Figure 1 can be provided statistical and/or substantially real time information regarding the power consumed. The consumption information can be provided on a per power circuit, per specific device group, room etc., or even per specific device basis.

A keep alive clock is defined with a value whereby if no ON/OFF event has been received during that period the sensor only reports the power drawn by the power circuit and any changes than affect the overall power consumption. For example, the keep alive timer can be set to have a duration The breaker unit is provided with an emergency switch. This can be controlled via the central data processing system in response to the determinations, for example when overloading, overheating or another abnormal condition is detected. The tripping can be provided per specific device or device group basis, or the entire power circuit can be switched off.

In addition to, or instead of, power consumption determination other control actions are possible. For example, information of devices that are ON can be transmitted to the user terminal and the user can be displayed such state information remotely. For example, the user terminal 48 of Figure 1 can display a listing of devices ON, or an indication of a device that is ON in circumstances where it in all likelihood should not be ON. For example, an alert can be given if a kettle, coffee maker, iron, oven or the like is determined to be ON when no-one is home.

According to a possibility the system uses information from a user location device and notifies the user of e.g. an oven that is on when the user is not at home. According to a possibility a positioning system of the user terminal, e.g. GPS, cellular network based positioning, or the like, is used. If it is determined that the user terminal is not at home or close thereby, an alert is given through the user terminal in response to detection of a predefined electrical device being ON.

Thus a user can be alerted of an abnormal situation. The user can then use the terminal to take an appropriate control action, for example control tripping of the system or parts thereof. Thus the user can take an action such as switch off entire power circuit or a part of the power circuit, switch off or otherwise change the operational state of at least one device drawing current from the power circuit and so on by means of the user interface presented by means of a client application running on the terminal.

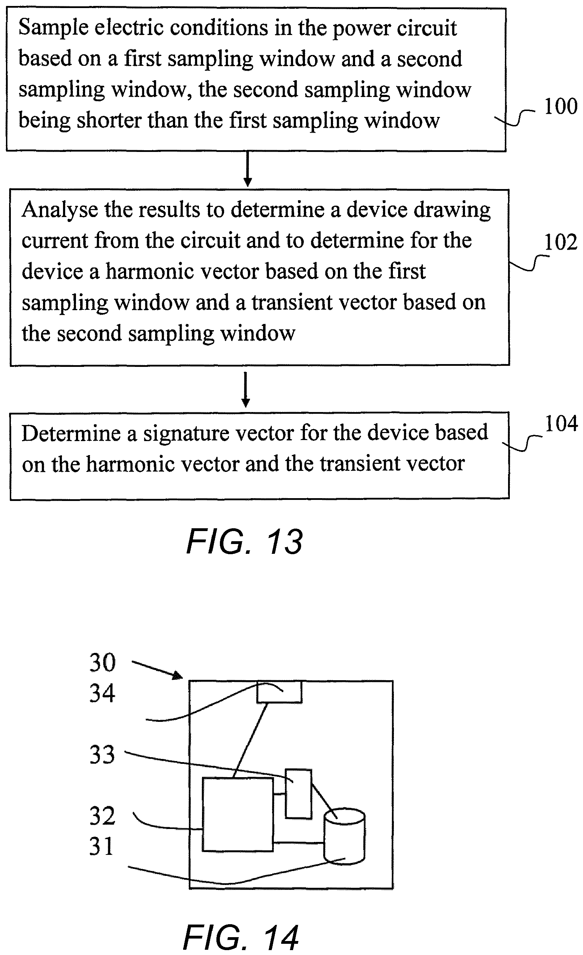

Figure 13 shows a flowchart in accordance with an example. In the shown method for monitoring a power circuit, electric conditions in the power circuit are sampled at 100 by a sensor device attached to the power circuit based on a first sampling window and a second sampling window, the second sampling window being shorter than the first sampling window. Results of the sampling are analysed at 102 to determine at least one device drawing current from the circuit and to determine for the at least one device a harmonic vector based on the first sampling window and a transient vector based on the second sampling window. A signature vector is then determined at 104 for the at least one device based on the harmonic vector and the transient vector.

Figure 14 shows an example of control apparatus for a sensor device capable of providing the above described functions for sampling, analysing and machine learning capabilities in relation to a power circuit and devices connected thereto. The control apparatus 30 can be for example placed within an enclosure of a device of the type shown in Figure 2, and mounted in a standard rack of a circuit breaker box. The control apparatus comprises at least one memory 31, at least one data processing unit 32, 33 and an input/output interface 34. Via the interface the control apparatus can be coupled to a data network, either over a wireless connection or via a fixed connection, and further to a central unit comprising a database for processing and/or storing signature vector information. At least a part of analysis, determining and/or machine learning functions can be provided by the central data processing unit. The control apparatus can be configured to execute an appropriate software code to provide the functions. The control apparatus can also be interconnected with other control entities.

The embodiments and their combinations or subdivisions may be implemented as methods, apparatuses, or computer program products. Methods for downloading computer program code for performing the same may also be provided. Computer program products may be stored on non-transitory computer-readable media, such as memory chips, or memory blocks implemented within the processor, magnetic media such as hard disk or floppy disks, and optical media such as for example DVD and the data variants thereof, CD, magnetic disk, or semiconductor memory. Method steps may be implemented using instructions operable to cause a computer to perform the method steps using a processor and a memory. The instructions may be stored on any computer-readable media, such as memory or nonvolatile storage.

The data processors may be of any type suitable to the local technical environment, and may include one or more of general purpose computers, special purpose computers, microprocessors, digital signal processors (DSPs), application specific integrated circuits (ASIC), gate level circuits and processors based on multi core processor architecture, as non-limiting examples. The data processing may be distributed across several data processing modules. A data processor may be provided by means of, for example, at least one chip. The memory or memories may be of any type suitable to the local technical environment and may be implemented using any suitable data storage technology, such as semiconductor based memory devices, magnetic memory devices and systems, optical memory devices and systems, fixed memory and removable memory.

While various aspects of the invention may be illustrated and described as block diagrams, flow charts, or using some other pictorial representation, it is well understood that these blocks, apparatus, systems, techniques or methods described herein may be implemented in, as non-limiting examples, hardware, software, firmware, special purpose circuits or logic, general purpose hardware or controller or other computing devices, or some combination thereof.

The foregoing description provides by way of exemplary and non-limiting examples a full and informative description of exemplary embodiments of the invention. However, various modifications and adaptations may become apparent to those skilled in the relevant arts in view of the foregoing description, when read in conjunction with the accompanying drawings and the appended claims. All such and similar modifications of the teachings of this invention will still fall within the scope of this invention as defined by the appended claims.

**Claims**

**1.** A power circuit monitoring device (10), comprising:

an enclosure,
monitoring electronics in the enclosure, the monitoring electronics comprising at least one processing unit and at least one memory unit configured to determine signature vector information for the power circuit (2) and identify individual devices (5) connected to the power circuit based on the determined signature vector information, and
connectors (14, 16) configured to engage with the power circuit, **characterized in that** at least one of the connectors is configured to be fastened by a magnet (17, 19) to an external part of a contact element (7, 8) of a breaker module (6A) of the power circuit through an opening in the breaker module.

**2.** The power circuit monitoring device according to claim 1, wherein the at least one connector (14, 16) is configured for engagement with a wire fixing screw end (7, 8) of the breaker module (6A).

**3.** The power circuit monitoring device according to claim 1 or 2, wherein the magnet (17, 19) is attached at the probe end of at least one connector wire (13, 15) for fastening of the probe to the contact element.

**4.** The power circuit monitoring device according to any of claims 1 to 3, configured to monitor for changes in operation of one or more devices (5) connected to the power circuit (2).

**5.** A system for managing a power supply circuit, the system comprising:

a power circuit monitoring device (10) according to any of claims 1 to 4, wherein the power circuit monitoring device is configured for fastening in a mounting unit of a breaker unit (3) in place of a standard breaker module (6C),
a central data processing device (40) comprising a database (44) and a processor apparatus (42) for receiving information from the power circuit monitoring device (10), and
a communication interface (49) for communicating with a user terminal (48) data associated with the power circuit.

**6.** The system for managing a power supply circuit according to claim 5, configured to perform a control action in response to a determined event in association with a device (5) connected to the power supply circuit (2).

**7.** A method of installing a power circuit monitoring device (10) comprising monitoring electronics configured to determine signature vector information for a power circuit (2) and identify individual devices (5) connected to the power circuit based on the signature vector information, **characterized by** the method comprising:

attaching the monitoring device (10) in a railing of (9) a breaker unit (3) of the power circuit in place of a standard breaker module (6C) for determining harmonics on the power circuit,
connecting connectors (14, 16) extending from the monitoring device (10) to the power circuit for measurement, by the monitoring device, of voltage and current drawn by devices connected to the power circuit, and
using magnetism to fasten at least one of the connectors (14, 16) of the monitoring device (10) to an external part of a contact element (7, 8) (7, 8) of a breaker module (6A) of the breaker unit (3) through an opening in the breaker module.

**8.** The method according to claim 7, comprising attaching at least a part of the connectors (14, 16) to the power circuit by inserting probes to openings of the breaker module (6A) of the breaker unit and fastening the probes to the contact elements (7, 8) by magnets (17, 19) included in the probes.

**9.** The method according to claim 7 or 8, comprising engaging said at least one of the connectors (14, 16) with a wire fixing screw end (7, 8) of the breaker module (6A).

**10.** The method according to any of claims 7 to 9, comprising monitoring for changes in operation of one or more devices (5) connected to the power circuit (2).

**11.** The method according to any of claims 7 to 10, comprising communicating (49) data with a user terminal (48) associated with the power circuit.

**12.** The method according to any of claims 7 to 11, comprising performing a control action in response to a determined event in association with a device (5) connected to the power supply circuit (2).

**Patentansprüche**

**1.** Leistungsschaltungsüberwachungsvorrichtung (10), umfassend:

ein Gehäuse,
Überwachungselektronik im Gehäuse, wobei die Überwachungselektronik mindestens eine Verarbeitungseinheit und mindestens eine Speichereinheit umfasst, die dazu ausgelegt sind, Signaturvektorinformationen für die Leistungsschaltung (2) zu bestimmen und einzelne mit der Leistungsschaltung verbundene Vorrichtungen (5) basierend auf den bestimmten Signaturvektorinformationen zu identifizieren, und

Verbinder (14, 16), die dazu ausgelegt sind, mit der Leistungsschaltung in Kontakt zu gelangen, **dadurch gekennzeichnet, dass** mindestens einer der Verbinder dazu ausgelegt ist, durch einen Magneten (17, 19) an einem äußeren Teil eines Kontaktelements (7, 8) eines Unterbrechermoduls (6A) der Leistungsschaltung durch eine Öffnung im Unterbrechermodul befestigt zu werden.

2. Leistungsschaltungsüberwachungsvorrichtung nach Anspruch 1, wobei der mindestens eine Verbinder (14, 16) zum Eingriff mit einem Drahtbefestigungsschraubenende (7, 8) des Unterbrechermoduls (6A) ausgelegt ist.

3. Leistungsschaltungsüberwachungsvorrichtung nach Anspruch 1 oder 2, wobei der Magnet (17, 19) am Fühlerende mindestens eines Anschlussdrahtes (13, 15) zur Befestigung des Fühlers am Kontaktelement angebracht ist.

4. Leistungsschaltungsüberwachungsvorrichtung nach einem der Ansprüche 1 bis 3, die dazu ausgelegt ist, Änderungen im Betrieb einer oder mehrerer Vorrichtungen (5), die mit der Leistungsschaltung (2) verbunden sind, zu überwachen.

5. System zur Handhabung einer Stromversorgungsschaltung, wobei das System umfasst:

eine Leistungsschaltungsüberwachungsvorrichtung (10) nach einem der Ansprüche 1 bis 4, wobei die Leistungsschaltungsüberwachungsvorrichtung dazu ausgelegt ist, in einer Montageeinheit einer Unterbrechereinheit (3) anstelle eines Standard-Unterbrechermoduls (6C) befestigt zu werden,

eine zentrale Datenverarbeitungsvorrichtung (40) umfassend eine Datenbank (44) und eine Prozessorvorrichtung (42) zum Empfangen von Informationen von der Leistungsschaltungsüberwachungsvorrichtung (10), und

eine Kommunikationsschnittstelle (49) zum Kommunizieren von Daten im Zusammenhang mit der Leistungsschaltung mit einem Benutzerendgerät (48).

6. System zum Handhaben einer Stromversorgungsschaltung nach Anspruch 5, die dazu ausgelegt ist, eine Steuerungsmaßnahme als Reaktion auf ein bestimmtes Ereignis im Zusammenhang mit einer mit der Stromversorgungsschaltung (2) verbundenen Vorrichtung (5) durchzuführen.

7. Verfahren zum Installieren einer Leistungsschaltungsüberwachungsvorrichtung (10), die eine Überwachungselektronik umfasst, die dazu ausgelegt ist, Signaturvektorinformationen für eine Leistungsschaltung (2) zu bestimmen und einzelne mit der Leistungsschaltung verbundene Vorrichtungen (5) basierend auf den Signaturvektorinformationen zu identifizieren, **dadurch gekennzeichnet, dass** das Verfahren umfasst:

Anbringen der Überwachungsvorrichtung (10) in einem Holm (9) einer Unterbrechereinheit (3) der Leistungsschaltung anstelle eines Standard-Unterbrechermoduls (6C) zum Bestimmen von Oberwellen auf der Leistungsschaltung,

Anschließen von Verbindern (14, 16), die sich von der Überwachungsvorrichtung (10) zur Leistungsschaltung erstrecken, zum Messen von Spannung und Strom, die von mit der Leistungsschaltung verbundenen Vorrichtungen aufgenommen werden, durch die Überwachungsvorrichtung, und

Verwenden von Magnetismus zum Befestigen mindestens eines der Verbinder (14, 16) der Überwachungsvorrichtung (10) an einem äußeren Teil eines Kontaktelements (7, 8) eines Unterbrechermoduls (6A) der Unterbrechereinheit (3) durch eine Öffnung im Unterbrechermodul.

8. Verfahren nach Anspruch 7, umfassend das Befestigen mindestens eines Teils der Verbinder (14, 16) an der Leistungsschaltung durch Einsetzen von Fühlern in Öffnungen des Unterbrechermoduls (6A) der Unterbrechereinheit und Befestigen der Fühler an den Kontaktelementen (7, 8) durch in den Fühlern befindliche Magnete (17, 19).

9. Verfahren nach Anspruch 7 oder 8, umfassend das Arretieren des mindestens einen der Verbinder (14, 16) mit einem Drahtbefestigungsschraubenende (7, 8) des Unterbrechermoduls (6A).

10. Verfahren nach einem der Ansprüche 7 bis 9, umfassend das Überwachen auf Änderungen im Betrieb einer oder mehrerer Vorrichtungen (5), die mit der Leistungsschaltung (2) verbunden sind.

11. Verfahren nach einem der Ansprüche 7 bis 10, umfassend das Kommunizieren (49) von Daten mit einem der Leistungsschaltung zugeordneten Benutzerendgerät (48).

**12.** Verfahren nach einem der Ansprüche 7 bis 11, umfassend das Durchführen einer Steuerungsmaßnahme als Reaktion auf ein bestimmtes Ereignis im Zusammenhang mit einer mit der Stromversorgungsschaltung (2) verbundenen Vorrichtung (5).

**Revendications**

**1.** Dispositif de surveillance de circuit d'alimentation (10), comprenant :

un boîtier,
une électronique de surveillance dans le boîtier, cette électronique de surveillance comprenant au moins une unité de traitement et au moins une unité de mémoire configurées de façon à déterminer des informations de vecteur de signature pour le circuit d'alimentation (2) et à identifier les dispositifs individuels (5) connectés au circuit d'alimentation en se basant sur les informations de vecteur de signature déterminées, et
des connecteurs (14, 16) configurés de façon à s'engager avec le circuit d'alimentation, **caractérisé en ce qu'**au moins un de ces connecteurs est configuré de façon à être attaché par un aimant (17, 19) à une partie externe d'un élément de contact (7, 8) d'un module sectionneur (6A) du circuit d'alimentation à travers une ouverture dans le module sectionneur.

**2.** Dispositif de surveillance de circuit d'alimentation selon la revendication 1, dans lequel l'au moins un connecteur (14, 16) est configuré de façon à s'engager avec une extrémité à vis de fixation de fil (7, 8) du module sectionneur (6A).

**3.** Dispositif de surveillance de circuit d'alimentation selon la revendication 1 ou 2, dans lequel l'aimant (17, 19) est attaché à l'extrémité sonde d'au moins un fil connecteur (13, 15) pour attacher la sonde à l'élément de contact.

**4.** Dispositif de surveillance de circuit d'alimentation selon l'une quelconque des revendications 1 à 3, configuré de façon à surveiller les changements dans le fonctionnement d'un ou de plusieurs dispositifs (5) connectés au circuit d'alimentation (2).

**5.** Système pour gérer un circuit d'alimentation, ce système comprenant :

un dispositif de surveillance de circuit d'alimentation (10) selon l'une quelconque des revendications 1 à 4, ce dispositif de surveillance de circuit d'alimentation étant configuré de façon à être attaché dans une unité de montage d'une unité sectionneur (3) à la place d'un module sectionneur standard (6C),
un dispositif central de traitement des données (40) comprenant une base de données (44) et un appareil de traitement (42) pour recevoir des informations du dispositif de surveillance de circuit d'alimentation (10), et
une interface de communication (49) pour communiquer avec un terminal utilisateur (48) les données associées au circuit d'alimentation.

**6.** Système pour gérer un circuit d'alimentation selon la revendication 5, configuré de façon à exécuter une action de commande en réponse à un événement déterminé en association avec un dispositif (5) connecté au circuit d'alimentation (2).

**7.** Procédé d'installation d'un dispositif de surveillance de circuit d'alimentation (10) comprenant une électronique configurée de façon à déterminer des informations de vecteur de signature pour un circuit d'alimentation (2) et à identifier des dispositifs individuels (5) connectés au circuit d'alimentation en se basant sur les informations de vecteur de signature, ce procédé étant **caractérisé en ce qu'**il comprend :

la fixation du dispositif de surveillance (10) dans un rail (9) d'une unité sectionneur (3) du circuit d'alimentation à la place d'un module sectionneur standard (6C) pour déterminer les harmoniques sur le circuit d'alimentation,
la connexion de connecteurs (14, 16) s'étendant du dispositif de surveillance (10) au circuit d'alimentation pour la mesure, par le dispositif de surveillance, de la tension et du courant prélevé par les dispositifs connectés au circuit d'alimentation, et
l'utilisation de magnétisme pour attacher au moins un des connecteurs (14, 16) du dispositif de surveillance (10) à une partie externe d'un élément de contact (7, 8) d'un module sectionneur (6A) de l'unité sectionneur (3) à travers une ouverture dans le module sectionneur.

**8.** Procédé selon la revendication 7, comprenant la fixation d'au moins une partie des connecteurs (14, 16) au circuit d'alimentation en insérant des sondes dans les ouvertures du module sectionneur (6A) de l'unité sectionneur et en attachant ces sondes aux éléments de contact (7, 8) par des aimants (17, 19) compris dans les sondes.

9. Procédé selon la revendication 7 ou 8, comprenant l'engagement dudit au moins un des connecteurs (14, 16) avec une extrémité à vis de fixation de fil (7, 8) du module sectionneur (6A).

10. Procédé selon l'une quelconque des revendications 7 à 9, comprenant la surveillance des changements dans le fonctionnement d'un ou de plusieurs dispositifs (5) connectés au circuit d'alimentation (2).

11. Procédé selon l'une quelconque des revendications 7 à 10, comprenant la communication (49) des données avec un terminal utilisateur (48) associé au circuit d'alimentation.

12. Procédé selon l'une quelconque des revendications 7 à 11, comprenant l'exécution d'une action de commande en réponse à un événement déterminé en association avec un dispositif (5) connecté au circuit d'alimentation (2) .

FIG. 1

*FIG. 2*

*FIG. 3*

EP 3 292 417 B1

5<sup>th</sup> harmonic

i<sup>th</sup> harmonic

3<sup>rd</sup> harmonic

9<sup>th</sup> harmonic

1<sup>st</sup> harmonic

$^1H$

$^1H_y$

$^1H_x$

$^1\Theta$

7<sup>th</sup> harmonic

*FIG. 4*

FIG. 5

FIG. 6

FIG. 7

*FIG. 8*

*FIG. 9*

FIG. 10

*FIG. 11A*

EP 3 292 417 B1

*FIG. 11B*

volt@ reading ~110

Switch off event | Switch on event

120~ Harmonics calculation

Transient calculation ~112

122~ Match the signature with "On" database entries

"On" appliance signature database

Harmonics calculation ~113

"On" match found | No "On" match found

126 | 124

Match the signature with "Off" database entries

"Off" appliance signature database

Add consumption to the match

New appliance signature

"Off" match found | No "Off" match found

118 | 116

Consumption update of the database

Update of the database

Add consumption to the match

New appliance signature

Consumption update of the database

Update of the database

FIG. 12

130~ "On" and "Off" appliance control process

EP 3 292 417 B1

Sample electric conditions in the power circuit based on a first sampling window and a second sampling window, the second sampling window being shorter than the first sampling window

~ 100

Analyse the results to determine a device drawing current from the circuit and to determine for the device a harmonic vector based on the first sampling window and a transient vector based on the second sampling window

102

Determine a signature vector for the device based on the harmonic vector and the transient vector

104

## FIG. 13

30
34
33
32
31

## FIG. 14

**EP 3 292 417 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2012160062 A1